# EUROPEAN PATENT APPLICATION

(11) **EP 2 323 303 A1**
(43) Date of publication of application: **18.05.2011**
(21) Application number: 09811269.1
(22) Date of filing: 01.09.2009
(51) Int. Cl.: H04L 1/18, H03M 13/19, H03M 13/47, H04W 28/04

(54) **WIRELESS COMMUNICATION DEVICE AND WIRELESS COMMUNICATION METHOD**

(30) Priority: 02.09.2008 JP 2008225071
(71) Applicant: Panasonic Corporation, Kadoma-shi Osaka 571-8501 (JP)
(72) Inventor: YOSHII, Isamu c/o Panasonic Corporation IPROC, Chuo-ku, Osaka-shi, Osaka 540-6207 (JP); KURI, Kenichi c/o Panasonic Corporation IPROC, Chuo-ku, Osaka-shi, Osaka 540-6207 (JP); KISHIGAMI, Takaaki c/o Panasonic Corporation IPROC, Chuo-ku, Osaka-shi, Osaka 540-6207 (JP)
(74) Representative: Grünecker, Kinkeldey, Stockmair & Schwanhäusser Anwaltssozietät
(86) International application number: PCT/JP2009/004291
(87) International publication number: WO 2010/026739

(57) **Abstract**

Disclosed is a wireless communication device capable of always obtaining the optimum error rate characteristic and of keeping the number of retransmissions to a minimum for IR-based HARQ which uses LDPC encoding in the error correction encoding. With the device, an RV control unit (102) controls the system check bit transmission sequence such that all of the system check bits included in an LDPC code word are transmitted with the first transmission in sequence from the smallest column weight of a check matrix, and controls the transmission sequence of multiple RVs such that multiple RVs comprising only system check bits are transmitted in sequence from the smallest column weight when an RV is transmitted additionally after all of the parity bits included in an LDPC code word have been transmitted. In addition, a modulation unit (103) maps a symbol, composed of system check bits belonging to each of the multiple RVs and the transmission sequences of which are controlled by the RV control unit (102), to a signal point which differs from the signal point to which was mapped a symbol composed of the system check bits transmitted with the first transmission.

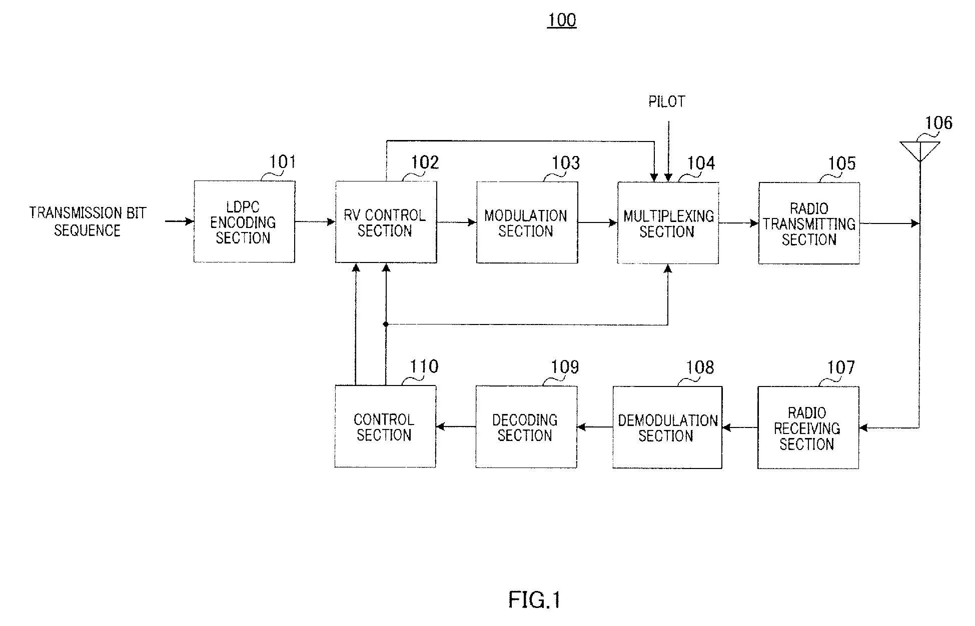

## Description

### Technical Field

The present invention relates to a radio communication apparatus and radio communication method.

### Background Art

In recent years, multimedia communication such as data communication and video streaming has continued to increase in popularity. Therefore, data sizes are expected to increase even more in the future, and growing demands for higher data rates for mobile communication services are also anticipated.

Thus, a fourth-generation mobile communication system called IMT-Advanced has been studied by the ITU-R (International Telecommunication Union Radio Communication Sector), and an LDPC (Low-Density Parity-Check) code is one of error correction codes for implementing a downlink speed of up to 1 Gbps. Use of an LDPC code as an error correction code enables decoding processing to be parallelized, allowing decoding processing to be speeded up compared with the use of a turbo code that requires repeated serial execution of decoding processing.

LDPC encoding is performed using a parity check matrix containing a large number of 0's and a small number of 1's. A transmitting-side radio communication apparatus encodes a transmission bit sequence using a parity check matrix, and obtains an LDPC codeword comprising systematic bits and parity bits. A receiving-side radio communication apparatus decodes received data by iteratively executing passing of the likelihood of individual bits in the parity check matrix row direction and the parity check matrix column direction, and obtains a received bit sequence. Here, the number of 1's contained in each column in a parity check matrix is called the column degree, and the number of 1's contained in each row in a parity check matrix is called the row degree. A parity check matrix can be represented by a Tanner graph, which is a two-part graph comprising rows and columns. In a Tanner graph, each row of a parity check matrix is called a check node, and each column of a parity check matrix is called a variable node. Variable nodes and check nodes of a Tanner graph are connected in accordance with the arrangement of 1's in the parity check matrix, and a receiving-side radio communication apparatus decodes receive data by iteratively executing passing of likelihoods between connected nodes, and obtains a received bit sequence.

HARQ (Hybrid ARQ) combines ARQ (Automatic Repeat reQuest) and error correction coding. With HARQ, a receiving-side radio communication apparatus feeds back an ACK (Acknowledgment) signal as a response signal to the transmitting-side radio communication apparatus if there are no errors in receive data, and feeds back a NACK (Negative Acknowledgment) signal if there is an error. Also, the receiving-side radio communication apparatus combines retransmitted data from the transmitting-side radio communication apparatus with received data in the past, and decodes the combined data. By this means SINR and coding gain improvements are achieved, and received data can be decoded with fewer retransmissions than in the case of ordinary ARQ.

IR (Incremental Redundancy) is one of HARQ methods. With the IR method, a codeword is divided into a plurality of redundancy versions (hereinafter referred to as "RVs"), which are retransmission data units, and these RVs are transmitted sequentially.

One conventional IR-type HARQ method composes each RV by extracting coded bits randomly from a codeword (refer to Non-Patent Literature 1).

### Citation List

### Non-Patent Literature.

NPL 1
3GPP-TS.25.212 Sec.4.2.7.5 "Rate matching pattern determination," 2002/03

### Summary of Invention

### Technical Problem.

Here, in LDPC encoding, error rate performance varies between variable nodes according to the number of check node connections of each variable node. Therefore, when IR-type HARQ is performed using an LDPC code as an error correction code, since an RV is composed by simply extracting coded bits randomly from a codeword disregarding the number of connections, it may not be possible for optimal error rate performance to be obtained, resulting in an increase in the number of retransmissions.

It is an object of the present invention to provide a radio communication method that enables optimal error rate performance always to be obtained and the number of retransmissions to be minimized in IR-type HARQ using an LDPC code as an error correction code.

### Solution to Problem.

A radio communication apparatus of the present invention is a radio communication apparatus of a transmitting-side that extracts each bit of a codeword comprising systematic bits and parity bits obtained by LDPC encoding based on a parity check matrix, to compose a plurality of redundancy versions, and transmits the plurality of redundancy versions sequentially, and employs a configuration that includes: an encoding section that encodes a transmission bit sequence by the LDPC encoding based on the parity check matrix to generate the codeword; a control section that controls a transmission order of the systematic bits and a transmission order of the plurality of redundancy versions according to a column degree of the parity check matrix corresponding to each bit of the codeword; and a modulation section that modulates the systematic bit or the plurality of redundancy versions to generate a symbol; wherein the control section controls the transmission order of the systematic bits so that all systematic bits contained in the codeword are transmitted in an initial transmission in ascending order of the column degree, controls the transmission order of the plurality of redundancy versions so that the plurality of redundancy versions composed of only parity bits are transmitted in descending order of the column degree until all parity bits contained in the codeword are transmitted, and when a redundancy version is further transmitted after all parity bits contained in the codeword have been transmitted, controls a transmission order of the plurality of redundancy versions so that the plurality of redundancy versions composed of only systematic bits are transmitted in ascending order of the column degree.

### Advantageous Effects of Invention.

The present invention enables optimal error rate performance always to be obtained and the number of retransmissions to be minimized in IR-type HARQ using an LDPC code as an error correction code.

### Brief Description of Drawings.

FIG.1 is a block configuration diagram of a transmitting-side radio communication apparatus according to Embodiment 1 of the present invention;
FIG.2 is a parity check matrix according to Embodiment 1 of the present invention;
FIG.3 is a Tanner graph according to Embodiment 1 of the present invention;
FIG.4 is a drawing showing an RV configuration according to Embodiment 1 of the present invention;
FIG.5 is a drawing showing transmission processing according to Embodiment 1 of the present invention;
FIG.6 is a block configuration diagram of a receiving-side radio communication apparatus according to Embodiment 1 of the present invention;
FIG.7 is a drawing showing combining processing according to Embodiment 1 of the present invention;
FIG.8 is a drawing showing transmission processing according to Embodiment 2 of the present invention;
FIG.9 is a drawing showing an RV configuration according to Embodiment 3 of the present invention;
FIG.10 is a drawing showing transmission processing according to Embodiment 3 of the present invention;
FIG.11 is a drawing showing a 16QAM constellation according to Embodiment 4 of the present invention;
FIG.12 is a drawing showing an RV configuration according to Embodiment 4 of the present invention; and
FIG.13 is a drawing showing transmission processing according to Embodiment 4 of the present invention.

### Description of Embodiments.

Embodiments of the present invention will now be described in detail with reference to the accompanying drawings.

### (Embodiment 1)

In this embodiment, the transmission order is controlled so that a plurality of RVs are transmitted in descending order of column degree in the parity check matrix until all parity bits contained in an LDPC codeword are transmitted.

The configuration of transmitting-side radio communication apparatus 100 according to this embodiment is shown in FIG.1.

In transmitting-side radio communication apparatus 100, a transmission bit sequence is input to LDPC encoding section 101. LDPC encoding section 101 encodes the transmission bit sequence by LDPC encoding based on a parity check matrix to generate an LDPC codeword comprising systematic bits and parity bits. This LDPC codeword is output to RV control section 102. LDPC encoding section 101 also outputs the parity check matrix to RV control section 102.

Based on the parity check matrix, RV control section 102 extracts each coded bit of the LDPC codeword and composes an RV, and outputs the RV to modulation section 103. RV control section 102 also outputs an RV index for identifying an RV output to modulation section 103 to multiplexing section 104. The number of RVs per transmission -- that is, the number of RVs per RV control section 102 output -- is given by (N · Rm(1-R))/(NRV · R), where N is the LDPC codeword length, Rm is the mother coding rate, R is the first transmission (initial transmission) coding rate input from control section 110, and NRV is the number of bits per RV (that is, the number of bits composing one RV). RV control section 102 stores an LDPC codeword input from LDPC encoding section 101. Then, in the first transmission (initial transmission), RV control section 102 outputs all systematic bits contained in the LDPC codeword and an RV to modulation section 103. Also, if a NACK signal is input from control section 110 -- that is, in a second or subsequent transmission (retransmission) -- RV control section 102 outputs an RV to modulation section 103, and if an ACK signal is input from control section 110, RV control section 102 stops RV output to modulation section 103 and discards the stored LDPC codeword. Details of RV control processing by RV control section 102 will be given later herein.

In a first transmission (initial transmission), modulation section 103 modulates the systematic bits and RV input from RV control section 102 and generates data symbols, and outputs them to multiplexing section 104. In a second or subsequent transmission (retransmission), modulation section 103 modulates an RV input from RV control section 102 and generates data symbols, and outputs them to characteristic parameter extraction section 104.

Multiplexing section 104 multiplexes a data symbol, pilot signal, and RV index, and a control signal input from control section 110, and outputs a generated multiplex signal to radio transmitting section 105.

Radio transmitting section 105 performs transmission processing such as D/A conversion, amplification, and up-conversion on the multiplex signal, and transmits the resulting signal to the receiving-side radio communication apparatus from antenna 106.

Meanwhile, radio receiving section 107 receives a control signal transmitted from the receiving-side radio communication apparatus via antenna 106, performs reception processing such as down-conversion and A/D conversion on the control signal, and outputs the resulting signal to demodulation section 108. A CQI (Channel Quality Indicator) and response signal (ACK signal or NACK signal) generated by the receiving-side radio communication apparatus are included in this control signal.

Demodulation section 108 demodulates the control signal and outputs the demodulated signal to decoding section 109.

Decoding section 109 decodes the control signal and outputs the CQI and response signal contained in the control signal to control section 110.

Control section 110 controls the post-RV-control coding rate according to the CQI. Then control section 110 outputs a control signal indicating the determined coding rate to RV control section 102 and multiplexing section 104. The higher the channel quality to which the CQI corresponds, the higher is the post-RV-control coding rate determined by control section 110. Control section 110 also outputs the response signal input from decoding section 109 to RV control section 102.

RV control processing by RV control section 102 will now be described in detail.

FIG.2 shows an 8-row × 12-column parity check matrix as an example. As shown here, a parity check matrix is represented by a matrix of M rows × N columns, and comprises 0's and 1's.

Each column of a parity check matrix corresponds to a coded bit of an LDPC codeword. That is to say, when LDPC encoding is performed using the parity check matrix shown in FIG.2, a 12-bit LDPC codeword is generated.

In the parity check matrix shown in FIG.2, the column degree of the first column is the number of 1's in the first column -- that is, 4 -- and the column degree of the second column is the number of 1's in the second column -- that is, 4. Thus, in the 12-bit LDPC codeword, the column degree of the 1'st bit is 4, and the column degree of the second bit is 4. The same kind of rationale also applies to the third through twelfth columns.

Similarly, in the parity check matrix shown in FIG.2, the row degree of the first row is the number of 1's in the first row -- that is, 4 -- and the row degree of the second row is the number of 1's in the second row -- that is, 6. The same kind of rationale also applies to the third through eighth rows.

The parity check matrix shown in FIG.2 can be represented by a Tanner graph comprising the rows and columns of the parity check matrix.

FIG.3 shows a Tanner graph corresponding to the parity check matrix in FIG.2. A Tanner graph comprises check nodes corresponding to the rows of a parity check matrix and variable nodes corresponding to the columns. That is to say, a Tanner graph corresponding to an 8-row × 12-column parity check matrix is a two-part graph comprising eight check nodes and 12 variable nodes.

Each variable node of a Tanner graph corresponds to a coded bit of the LDPC codeword.

Variable nodes and check nodes of a Tanner graph are connected in accordance with the arrangement of 1's in the parity check matrix.

A concrete description will be now given based on variable nodes. Variable node 1 of the Tanner graph shown in FIG.3 corresponds to the first column (N=1) of the parity check matrix shown in FIG.2. The column degree of the first column of the parity check matrix is 4, and rows in which a 1 is located in the first column are the second row, third row, sixth row, and eighth row. Thus, there are four connections at variable node 1 -- check node 2, check node 3, check node 6, and check node 8. Similarly, variable node 2 of the Tanner graph corresponds to the second column (N=2) of the parity check matrix, the column degree of the second column of the parity check matrix is 4, and rows in which a 1 is located in the second column are the first row, fourth row, fifth row, and seventh row. Thus, there are four connections at variable node 2 -- check node 1, check node 4, check node 5, and check node 7. The same kind of rationale also applies to variable node 3 through variable node 12.

Similarly, to give a concrete description based on check nodes, check node 1 of the Tanner graph shown in FIG.3 corresponds to the first row (M=1) of the parity check matrix shown in FIG.2. The row degree of the first row of the parity check matrix is 4, and columns in which a 1 is located in the first row are the second column, fourth column, eighth column, and eleventh column. Thus, there are four connections at check node 1 -- variable node 2, variable node 4, variable node 8, and variable node 11. Similarly, check node 2 of the Tanner graph corresponds to the second row (M=2) of the parity check matrix, the row degree of the second row of the parity check matrix is 6, and columns in which a 1 is located in the second row are the first column, third column, fourth column, fifth column, ninth column, and tenth column. Thus, there are six connections at check node 2 -- variable node 1, variable node 3, variable node 4, variable node 5, variable node 9, and variable node 10. The same kind of rationale also applies to check node 3 through check node 8.

Thus, in a Tanner graph, variable nodes and check nodes are connected in accordance with the arrangement of 1's in a parity check matrix. That is to say, the number of check nodes connected to each variable node in a Tanner graph is equal to the column degree of each column in a parity check matrix. Also, check nodes to which each variable node is connected in a Tanner graph are check nodes corresponding to rows in which a 1 is located in each column of a parity check matrix. Similarly, the number of variable nodes connected to each check node in a Tanner graph is equal to the row degree of each row in a parity check matrix, and variable nodes to which each check node is connected in a Tanner graph are variable nodes corresponding to columns in which a 1 is located in each row of a parity check matrix.

The receiving-side radio communication apparatus decodes received data by performing mutual passing of likelihoods between variable nodes via check nodes, and iteratively performing updating of the likelihood of each variable node. Consequently, the larger the number of check node connections of a variable node (the larger the column degree of a variable node), the greater is the number of times likelihood passing is performed to other variable nodes.

RV control section 102 controls the RV transmission order so that a plurality of RVs are transmitted in order from an RV comprised of a parity bit corresponding to a variable node with a larger number of check node connections -- that is, a variable node with a larger column degree -- until all parity bits contained in an LDPC codeword are transmitted..

A description will be now given in concrete terms. In the following description it is assumed that the transmission bit sequence length is 4 bits, the mother coding rate Rm is 1/3, and the number of bits per RV, NRV, is 2. Also, coding rate R determined by control section 110 is assumed to be 2/3. Therefore, when LDPC encoding is performed by LDPC encoding section 101 on a 4-bit transmission bit sequence using the parity check matrix shown in FIG.2, an N=12-bit LDPC codeword comprising four systematic bits and eight parity bits is generated. Also, since NRV = 2, RV control section 102 composes RVs with two parity bits each. Furthermore, RV control section 102 finds the number of RV per output from (N · Rm(1-R))/(NRV · R), and outputs one RV to modulation section 103 in one output.

RV control section 102 sorts parity bits corresponding to the fifth column through twelfth column of the parity check matrix shown in FIG.2 (variable node 5 through variable node 12 of the Tanner graph shown in FIG.3) in descending order of column degree in the parity check matrix (descending order of the number of check node connections), and extracts two parity bits at a time in order from a parity bit corresponding to a variable node of a larger column degree in the parity check matrix (a parity bit corresponding to a variable node with a larger number of check node connections) to compose one RV.

First, RV control section 102 compares column degrees among the fifth column through twelfth column corresponding to parity bits of the parity check matrix shown in FIG.2 (variable node 5 through variable node 12 of the Tanner graph shown in FIG.3).
That is to say, RV control section 102 compares column degree 2 of the fifth column (the number of check node connections at variable node 5 is two), column degree 1 of the sixth column (the number of check node connections at variable node 6 is one), column degree 2 of the seventh column (the number of check node connections at variable node 7 is two), column degree 4 of the eighth column (the number of check node connections at variable node 8 is four), column degree 3 of the ninth column (the number of check node connections at variable node 9 is three), column degree 4 of the tenth column (the number of check node connections at variable node 10 is four), column degree 3 of the eleventh column (the number of check node connections at variable node 11 is three), and column degree 1 of the twelfth column (the number of check node connections at variable node 12 is one).

Thus, as shown in FIG.2 and FIG.3, RV configuration rankings in the fifth column through twelfth column (variable node 5 through variable node 12) are as follows: the eighth column (variable node 8) and tenth column (variable node 10) first, the ninth column (variable node 9) and eleventh column (variable node 11) second, the fifth column (variable node 5) and seventh column (variable node 7) third, and the sixth column (variable node 6) and twelfth column (variable node 12) fourth.

Then, since the number of bits composing one RV (NRV) is two, RV control section 102 follows the RV configuration rankings and, as shown in FIG.4, sorts parity bits P1 through P8 in the 12-bit LDPC codeword comprising four systematic bits S1 through S4 and eight parity bits P1 through P8, and composes RV1 by extracting eighth column (variable node 8) parity bit P4 and tenth column (variable node 10) parity bit P6, composes RV2 by extracting ninth column (variable node 9) parity bit P5 and eleventh column (variable node 11) parity bit P7, composes RV3 by extracting fifth column (variable node 5) parity bit P1 and seventh column (variable node 7) parity bit P3, and composes RV4 by extracting sixth column (variable node 6) parity bit P2 and twelfth column (variable node 12) parity bit P8.

Thus, as shown in FIG.5, RV control section 102 outputs a 6-bit LDPC codeword composed of four systematic bits S1 through S4 and RV1 comprising two parity bits P4 and P6 to modulation section 103 in the first transmission (initial transmission), outputs RV2 comprising two parity bits P5 and P7 to modulation section 103 in the second transmission (first retransmission), outputs RV3 comprising two parity bits P1 and P3 to modulation section 103 in the third transmission (second retransmission), and outputs RV4 comprising two parity bits P2 and P8 to modulation section 103 in the fourth transmission (third retransmission). Also, RV control section 102 outputs "1" to multiplexing section 104 as the RV index in the first transmission (initial transmission), outputs "2" to multiplexing section 104 as the RV index in the second transmission (first retransmission), outputs "3" to multiplexing section 104 as the RV index in the third transmission (second retransmission), and outputs "4" to multiplexing section 104 as the RV index in the fourth transmission (third retransmission). As shown in FIG.5, coding rates R in these transmissions are 2/3 in the first transmission, 1/2 in the second transmission, 2/5 in the third transmission, and 1/3 -- the same as mother coding rate Rm -- in the fourth transmission.

By composing RVs by extracting parity bits in descending order of column degree in this way, RV control section 102 can control the order of transmission of RVs transmitted by radio communication apparatus 100 so that the RVs are transmitted in descending order of column degree.

Next, a receiving-side radio communication apparatus according to this embodiment will be described. The configuration of receiving-side radio communication apparatus 200 according to this embodiment is shown in FIG.6.

In receiving-side radio communication apparatus 200, a radio receiving section 202 receives a multiplex signal transmitted from transmitting-side radio communication apparatus 100 (FIG.1) via antenna 201, performs reception processing such as down-conversion and A/D conversion on the received signal, and outputs the resulting signal to demultiplexing section 203. This received signal includes a data symbol, pilot signal, and RV index, and a control signal indicating a coding rate determined by transmitting-side radio communication apparatus 100.

Demultiplexing section 203 separates the received signal into a data symbol, pilot signal, RV index, and control signal. Then demultiplexing section 203 outputs the data symbol to demodulation section 204, outputs the pilot signal to channel quality estimation section 208, and outputs the RV index and control signal to RV combining section 205.

Demodulation section 204 demodulates the data symbol and obtains received data, and outputs the received data to RV combining section 205.

When first transmission data (initial transmission data) is received, RV combining section 205 performs padding with padding bits having log-likelihood ratio 0 in the received data based on a parity check matrix (FIG.2) identical to the parity check matrix used by LDPC encoding section 101 (FIG.1), stores the obtained data, and also outputs the obtained data to LDPC decoding section 206. On the other hand, when second or subsequent transmission data (retransmission data) is received, RV combining section 205 combines the receive data with stored data based on the parity check matrix (FIG.2), stores the obtained data, and also outputs the obtained data to LDPC decoding section 206. If an ACK signal is input from error detection section 207 -- that is, if there are no errors in the received data decoded in LDPC decoding section 206 -- RV combining section 205 discards the stored received data. The number of padding bits used for padding when receiving first transmission data is determined based on the difference between the LDPC encoding section 101 (FIG.1) coding rate (mother coding rate) Rm and the coding rate indicated by the control signal input from demultiplexing section 203 (the coding rate determined by control section 110 (FIG.1)) R. Specifically, the number of padding bits used for padding is given by Nr((R/Rm)-1), where Nr indicates the data length of the received data. Details of RV combining processing by RV combining section 205 will be given later herein.

Using a parity check matrix (FIG.2) identical to the parity check matrix used by LDPC encoding section 101 (FIG.1), LDPC decoding section 206 performs LDPC decoding on data input from RV combining section 205, and obtains a decoded bit sequence. This decoded bit sequence is output to error detection section 207.

Error detection section 207 performs error detection on the decoded bit sequence input from LDPC decoding section 206. If the result of error detection is that there is an error in the decoded bits, error detection section 207 generates a NACK signal as a response signal and outputs this NACK signal to RV combining section 205 and a control signal generation section 209, whereas if there is no error in the decoded bits, error detection section 207 generates an ACK signal as a response signal and outputs this ACK signal to RV combining section 205 and control signal generation section 209. If there is no error in the decoded bits, error detection section 207 outputs the decoded bit sequence as a received bit sequence.

Meanwhile, channel quality estimation section 208 estimates the channel quality using the pilot signal input from demultiplexing section 203. Here, channel quality estimation section 208 estimates the SINR (Signal to Interference and Noise Ratio) of the pilot signal as channel quality, and outputs the estimated SINR to control signal generation section 209.

Control signal generation section 209 generates a CQI corresponding to the SINR input from channel quality estimation section 208, and outputs a control signal containing the generated CQI and the response signal input from error detection section 207 to encoding section 210.

Encoding section 210 encodes the control signal and outputs the resulting signal to a modulation section 211.

Modulation section 211 modulates the control signal and outputs the resulting signal to radio transmitting section 212.

Radio transmitting section 212 performs transmission processing such as D/A conversion, amplification, and up-conversion on the control signal, and transmits the resulting signal to transmitting-side radio communication apparatus 100 (FIG.1) from antenna 201.

RV combining processing by RV combining section 205 will now be described in detail. In the following description, a part corresponding to a systematic bit among columns of a parity check matrix or variable nodes of a Tanner graph is referred to as a systematic bit position, and a part corresponding to a parity bit is referred to as a parity bit position.

Here, since received data length Nr is 6 bits, coding rate R indicated by a control signal input from demultiplexing section 203 is 2/3, and mother coding rate Rm is 1/3, RV combining section 205 finds the number of padding bits used for padding from Nr((R/Rm)-1), and performs padding with six padding bits.

Prior to a first transmission (initial transmission), RV combining section 205 -- in the same way as RV control section 102 (FIG.1) -- sorts a plurality of parity bit positions in descending order of column degree in the parity check matrix (descending order of the number of check node connections), and extracts two parity bit positions at a time in order from a parity bit position corresponding to a variable node of a larger column degree (a parity bit position corresponding to a variable node with a larger number of check node connections) to compose one RV. Thus, in the same way as RV control section 102 (FIG.1), RV combining section 205 composes RV1 with eighth column (variable node 8) parity bit position P4 and tenth column (variable node 10) parity bit position P6, composes RV2 with ninth column (variable node 9) parity bit position P5 and eleventh column (variable node 11) parity bit position P7, composes RV3 with fifth column (variable node 5) parity bit position P1 and seventh column (variable node 7) parity bit position P3, and composes RV4 with sixth column (variable node 6) parity bit position P2 and twelfth column (variable node 12) parity bit position P8.

Then, as shown in FIG.7, when first transmission data (initial transmission data) is received, since the RV index input from demultiplexing section 203 is "1," RV combining section 205 determines that the bits of the 6-bit receive data are systematic bits S1 through S4 of the first column through fourth column (variable node 1 through variable node 4), and eighth column (variable node 8) parity bit P4 and tenth column (variable node 10) parity bit P6 composing RV1. Then RV combining section 205 places systematic bits S1 through S4 in the corresponding systematic bit positions, and places parity bit P4 and parity bit P6 in the corresponding parity bit positions. That is to say, as shown in FIG.7, RV combining section 205 places corresponding systematic bits S1 through S4 in the first column through fourth column (variable node 1 through variable node 4), places parity bit P4 in the eighth column (variable node 8), and places parity bit P6 in the tenth column (variable node 10). Then RV combining section 205 performs padding with padding bits P_{D} in positions equal to parity bit positions corresponding to columns other than columns corresponding to the identified bits -- that is, the fifth column through seventh column (variable node 5 through variable node 7), the ninth column (variable node 9), the eleventh column (variable node 11), and the twelfth column (variable node 12). In other words, as shown in FIG.7, RV combining section 205 performs padding with three padding bits P_{D} between S4 and P4 of the received data, performs padding with one padding bit P_{D} between P4 and P6, and performs padding with two padding bits P_{D} after P6. By this means, data with a data length of 12 bits -- the same as that of an LDPC codeword generated by transmitting-side radio communication apparatus 100 -- can be obtained. When first transmission data (initial transmission data) is received, 12-bit data comprising S1, S2, S3, S4, P_{D}, P_{D}, P_{D}, P4, P_{D}, P6, P_{D}, P_{D} is input to LDPC decoding section 206.

Next, as shown in FIG.7, when second transmission data (first retransmission data) is received, since the RV index input from demultiplexing section 203 is "2," RV combining section 205 determines that the bits of the 2-bit receive data are ninth column (variable node 9) parity bit P5 and eleventh column (variable node 11) parity bit P7 composing RV2. Therefore, in order to place parity bits P5 and P7 in their corresponding parity bit positions -- that is, the ninth column (variable node 9) and eleventh column (variable node 11) -- RV combining section 205 combines P5 and ninth column (variable node 9) padding bit P_{D}, and combines P7 and eleventh column (variable node 11) padding bit P_{D.} Thus, when second transmission data (first retransmission data) is received, 12-bit data comprising S1, S2, S3, S4, P_{D}, P_{D}, P_{D}, P4, P5, P6, P7, P_{D} is input to LDPC decoding section 206.

Also, as shown in FIG.7, when third transmission data (second retransmission data) is received, since the RV index input from demultiplexing section 203 is "3," RV combining section 205 determines that the bits of the 2-bit receive data are fifth column (variable node 5) parity bit P1 and seventh column (variable node 7) parity bit P3 composing RV3. Therefore, in order to place parity bits P1 and P3 in their corresponding parity bit positions -- that is, the fifth column (variable node 5) and seventh column (variable node 7) -- RV combining section 205 combines P1 and fifth column (variable node 5) padding bit P_{D}, and combines P3 and seventh column (variable node 7) padding bit P_{D}.
Thus, when third transmission data (second retransmission data) is received, 12-bit data comprising S1, S2, S3, S4, P1, P_{D}, P3, P4, P5, P6, P7, P_{D} is input to LDPC decoding section 206.

Furthermore, as shown in FIG.7, when fourth transmission data (third retransmission data) is received, since the RV index input from demultiplexing section 203 is "4," RV combining section 205 determines that the bits of the 2-bit receive data are sixth column (variable node 6) parity bit P2 and twelfth column (variable node 12) parity bit P8 composing RV4. Therefore, in order to place parity bits P2 and P8 in their corresponding parity bit positions -- that is, the sixth column (variable node 6) and twelfth column (variable node 12) -- RV combining section 205 combines P2 and sixth column (variable node 6) padding bit P_{D}, and combines P8 and twelfth column (variable node 12) padding bit P_{D}. Thus, when fourth transmission data (third retransmission data) is received, 12-bit data comprising S1, S2, S3, S4, P1, P2, P3, P4, P5, P6, P7, P8 is input to LDPC decoding section 206.

Thus, according to this embodiment, when an LDPC code is used in IR-type HARQ, the transmitting-side radio communication apparatus preferentially transmits parity bits having larger numbers of likelihood passes in LDPC decoding. Consequently, the receiving-side radio communication apparatus receives parity bits in order from a parity bit having a larger number of likelihood passes -- that is, from a parity bit that contributes more to likelihood updating -- among parity bits contained in an LDPC codeword, enabling LDPC decoding of receive data to be performed by passing of likelihoods to many bits from the time of 1'st reception. Thus, optimal error rate performance can always be obtained, and the number of retransmissions can be minimized.

### (Embodiment 2)

In this embodiment, a case is described in which RVs are further transmitted after all parity bits contained in an LDPC codeword are transmitted.

The operation of RV control section 102 according to this embodiment will now be described.

A variable node of fewer check node connections has fewer likelihood passes between variable nodes connected via check nodes. That is to say, a variable node of fewer check node connections receives fewer likelihoods and therefore yields a smaller effect of likelihood updating. Thus, when RVs are further transmitted after all parity bits contained in an LDPC codeword are transmitted, it is preferable to perform likelihood supplementation by preferentially retransmitting an RV composed of a variable node of a smaller column degree. That is to say, a variable node of fewer check node connections yields a greater effect of likelihood improvement by means of RV retransmission.

Thus, when RVs are further transmitted after all parity bits contained in an LDPC codeword are transmitted, RV control section 102 according to this embodiment controls the RV transmission order so that a plurality of RVs are transmitted in order from an RV composed of parity bits corresponding to a variable node of fewer check node connections -- that is, a variable node of a smaller column degree.

A description will be now given in concrete terms. First, in the same way as in Embodiment 1, RV control section 102 extracts parity bits whose column degrees of the parity check matrix shown in FIG.2 have been sorted in descending order two at a time, and composes RV1 through RV4, as shown in FIG.4. Then, in the same way as in Embodiment 1 (FIG.5), RV1 through RV4 are transmitted in order until the fourth transmission (third retransmission), and all of parity bits P1 through P8 contained in an LDPC codeword are transmitted, as shown in FIG.8.

Here, when RVs are further transmitted, RV control section 102 sorts parity bits corresponding to the fifth column through twelfth column of the parity check matrix shown in FIG.2 (variable node 5 through variable node 12 of the Tanner graph shown in FIG.3) in ascending order of column degree in the parity check matrix (ascending order of the number of check node connections), and extracts two parity bits at a time from a parity bit corresponding to a variable node of a smaller column degree (that is, from a parity bit corresponding to a variable node with fewer check node connections), to compose one RV. That is to say, RV control section 102 composes RVs so that the RVs are transmitted in the reverse order to that of RV transmission from the first transmission (initial transmission) through fourth transmission (third retransmission) -- that is, in the order: RV4, RV3, RV2, RV1. Thus, as shown in FIG.8, RV control section 102 outputs RV4 comprising parity bits P2 and P8 to modulation section 103 in the fifth transmission (fourth retransmission), and outputs RV3 comprising parity bits P1 and P3 to modulation section 103 in the sixth transmission (fifth retransmission). Also, RV control section 102 outputs "4" to multiplexing section 104 as the RV index in the fifth transmission (fourth retransmission), and outputs "3" to multiplexing section 104 as the RV index in the sixth transmission (fifth retransmission). As shown in FIG.8, coding rate R in these transmissions is 2/7 in the fifth transmission and 1/4 in the sixth transmission.

By composing RVs by extracting parity bits in ascending order of column degree of the parity bits in this way, RV control section 102 can control the order of transmission of RVs transmitted by radio communication apparatus 100 so that the RVs are transmitted in order from an RV composed of a parity bit of a smaller column degree.

RV combining section 205 of receiving-side radio communication apparatus 200 (FIG.6) determines RV configuration by means of the same method as RV control section 102, and identifies bits subject to combining in accordance with the RV indexes reported from transmitting-side radio communication apparatus 100.

Thus, according to this embodiment, the likelihood of a parity bit, for which the column degree is small and the effect of likelihood improvement is small, can be supplemented by RV retransmission. By this means, the effect of likelihood updating for a systematic bit connected to that parity bit via a check node can be indirectly improved by an improvement in the likelihood of that parity bit. Therefore, according to this embodiment, if there is still an error in decoded bits after all parity bits have been transmitted, and further RV transmissions are necessary after all RVs have been transmitted, the error rate performance of parity bits for which there is a greater possibility of error can be improved preferentially, and the number of retransmissions can be minimized.

### (Embodiment 3)

This embodiment differs from Embodiment 2 in that RVs comprising only systematic bits are transmitted.

That is to say, when RVs are further transmitted after all parity bits contained in an LDPC codeword are transmitted, RV control section 102 according to this embodiment controls the RV transmission order so that a plurality of RVs are transmitted in order from an RV composed of a systematic bit corresponding to a variable node of fewer check node connections -- that is, a variable node of a smaller column degree.

The operation of RV control section 102 according to this embodiment will now be described.

First, in the same way as in Embodiment 1, RV control section 102 extracts parity bits whose column degrees of the parity check matrix shown in FIG.2 have been sorted in descending order two at a time, and composes RV1 through RV4, as shown in FIG.9. Then, in the same way as in Embodiment 1 (FIG.5), RV1 through RV4 are transmitted in order until the fourth transmission (third retransmission), and all of parity bits P1 through P8 contained in an LDPC codeword are transmitted, as shown in FIG.10.

Here, when RVs are further transmitted, RV control section 102 sorts systematic bits corresponding to the first column through fourth column of the parity check matrix shown in FIG.2 (variable node 1 through variable node 4 of the Tanner graph shown in FIG.3) in ascending order of column degree in the parity check matrix (ascending order of the number of check node connections), and extracts two systematic bits at a time in order from a systematic bit corresponding to a variable node with a smaller column degree in the parity check matrix (that is, a systematic bit corresponding to a variable node with fewer check node connections) to compose one RV.

First, RV control section 102 compares column degrees among the first column through fourth column corresponding to systematic bits of the parity check matrix shown in FIG.2 (variable node 1 through variable node 4 of the Tanner graph shown in FIG.3). That is to say, RV control section 102 compares column degree 4 of the first column (the number of check node connections at variable node 1 is four), column degree 4 of the second column (the number of check node connections at variable node 2 is four), column degree 3 of the third column (the number of check node connections at variable node 3 is three), and column degree 3 of the fourth column (the number of check node connections at variable node 4 is three).

Thus, RV configuration rankings in the first column through fourth column (variable node 1 through variable node 4) are as follows: the third column (variable node 3) and fourth column (variable node 4) first, and the first column (variable node 1) and second column (variable node 2) second.

Then, since the number of bits composing one RV (NRV) is 2, RV control section 102 follows the RV configuration rankings and, as shown in FIG.9, sorts systematic bits S1 through S4, composes RV5 by extracting third column (variable node 3) systematic bit S3 and fourth column (variable node 4) systematic bit S4, and composes RV6 by extracting first column (variable node 1) systematic bit S1 and second column (variable node 2) systematic bit S2.

Thus, as shown in FIG.10, RV control section 102 outputs RV5 comprising systematic bits S3 and S4 to modulation section 103 in the fifth transmission (fourth retransmission), and outputs RV6 comprising systematic bits S1 and S2 to modulation section 103 in the sixth transmission (fifth retransmission). Also, RV control section 102 outputs "5" to multiplexing section 104 as the RV index in the fifth transmission (fourth retransmission), and outputs "6" to multiplexing section 104 as the RV index in the sixth transmission (fifth retransmission). As shown in FIG.10, coding rate R in these transmissions is 2/7 in the fifth transmission and 1/4 in the sixth transmission.

By composing RVs by extracting systematic bits in ascending order of column degree of systematic bits in this way, RV control section 102 can control the order of transmission of RVs transmitted by radio communication apparatus 100 so that the RVs are transmitted in order from an RV composed of a systematic bit of a smaller column degree.

RV combining section 205 of receiving-side radio communication apparatus 200 (FIG.6) determines RV configuration by means of the same method as RV control section 102, and identifies bits subject to combining in accordance with the RV indexes reported from transmitting-side radio communication apparatus 100.

Thus, according to this embodiment, the likelihood of a systematic bit having a smaller column degree and for which the effect of likelihood improvement is small, can be supplemented by RV retransmission. By this means, the likelihoods of all systematic bits can be aligned at a high level. Therefore, according to this embodiment, if there is still an error in decoded bits after all parity bits have been transmitted, and further RV transmissions are necessary after all RVs have been transmitted, the error rate performance of systematic bits for which there is a greater possibility of error among systematic bits that are actual transmission bits can be improved preferentially, and the number of retransmissions can be minimized.

### (Embodiment 4)

In this embodiment, a case is described in which constellation rearrangement (refer to IEEE 802.16m-08/771r1 "Enhanced HARQ scheme with Signal Constellation Rearrangement," 2008/07, for example) is used that changes (rearranges) a constellation in M-ary modulation such as 16QAM or 64QAM for each retransmission.

For example, in 16QAM, one symbol is composed of 4 bits, and a constellation is as shown in FIG.11. That is to say, a symbol modulated by means of 16QAM is mapped to one of the 16 constellation points shown in FIG.11. Here, the four bits composing a symbol are represented as (i₁, q₁, i₂, q₂). In this case, in a bit decision between adjacent constellation points, decision boundary lines for the upper two bits (i₁, q₁) are the I-axis and Q-axis shown in FIG.11, while decision boundary lines for the lower two bits (i₂, q₂) are the I-axis and Q-axis shown in FIG.11, and lines parallel to the I-axis and Q-axis and equidistant from each constellation point. Therefore, as shown in FIG.11, the width of a lower-2-bit (i₂, q₂) decision boundary is smaller than the width of an upper-2-bit (i₁, q₁) decision boundary. Consequently, a high likelihood can be obtained for the upper two bits (i₁, q₁), but only a low likelihood can be obtained for the lower two bits (i₂, q₂). That is to say, a bit error is more likely to occur for the lower two bits than for the upper two bits.

Thus, in constellation rearrangement, a transmitting-side radio communication apparatus equalizes likelihood for all the bits composing one symbol by switching around the upper two bits and lower two bits composing one symbol when transmitting. For example, in FIG.11, if (i₁, q₁, i₂, q₂) = (0, 0, 1, 1) was transmitted in the previous transmission, a symbol transmitted in a retransmission becomes (i₁, q₁, i₂, q₂) = (1, 1, 0, 0) by switching around the upper two bits and lower two bits. That is to say, (0, 0) had a high likelihood in the previous transmission since it was mapped to the upper two bits, but has a lower likelihood in a retransmission since it is mapped to the lower two bits. Conversely, (1, 1) had a low likelihood in the previous transmission since it was mapped to the lower two bits, but has a higher likelihood in a retransmission since it is mapped to the upper two bits. Applying constellation rearrangement to HARQ in this way enables likelihood to be improved equally for all the bits composing one symbol.

RV control section 102 (FIG.1) according to this embodiment controls the systematic bit transmission order so that systematic bits are transmitted in the first transmission (initial transmission) from a systematic bit corresponding to a variable node with a smaller number of check node connections -- that is, a variable node of a smaller column degree. Also, as in Embodiment 3, when RVs are further transmitted after all parity bits contained in an LDPC codeword have been transmitted, RV control section 102 controls the RV transmission order so that a plurality of RVs are transmitted in order from an RV composed of only a systematic bit corresponding to a variable node of a smaller column degree.

Modulation section 103 generates a symbol by modulating a codeword (systematic bit or RV) input from RV control section 102, using M-ary modulation such as 16QAM or 64QAM. Also, in a second and subsequent transmission (retransmission), if an RV input from RV control section 102 is the same as a bit sequence transmitted in the previous transmission or before, modulation section 103 performs mapping with a symbol composed by that bit sequence mapped to a different constellation point from that mapped to in the previous transmission (that is, with constellation rearrangement executed). Here, when RVs are further transmitted after all parity bits contained in an LDPC codeword have been transmitted, modulation section 103 maps a symbol composed of systematic bits belonging to each of the plurality of RVs whose transmission order is controlled by RV control section 102 to a constellation point different from the constellation point to which a symbol composed of systematic bits transmitted in the first transmission (initial transmission) was mapped. For example, if bits b1, b2, b3, and b4 were mapped to (i₁, q₁, i₂, q₂) = (b1, b2, b3, b4) in the previous transmission (here the first transmission (initial transmission)), in a retransmission (here, when RVs are further transmitted after all parity bits contained in an LDPC codeword have been transmitted), modulation section 103 switches around the upper two bits (i₁, q₁) and lower two bits (i₂, q₂) of the previous transmission, and performs mapping to (i₁, q₁, i₂, q₂) = (b3, b4, b1, b2). In this way, modulation section 103 maps a symbol composed of bit sequence b1, b2, b3, and b4 onto mutually different constellation points in the previous transmission and a retransmission.

The operation of RV control section 102 according to this embodiment will now be described. Here, it is assumed that the transmission bit sequence length is 8 bits, mother coding rate Rm is 1/3, the number of bits per RV, NRV, is 4, and coding rate R determined by control section 110 is 2/3. Therefore, when LDPC encoding is performed by LDPC encoding section 101 on an 8-bit transmission bit sequence, an N=24 LDPC codeword comprising eight systematic bits (S1 through S8) and sixteen parity bits (PI through P16) is generated by LDPC encoding section 101. Also, RV control section 102 finds the number of RVs per output from (N · Rm(1-R))/(NRV · R), and outputs one RV to modulation section 103 in one output. Furthermore, since NRV = 4, RV control section 102 composes RVs with four parity bits each, and obtains a 12-bit LDPC codeword containing an RV composed of 4 bits as first transmission data (initial transmission data). It is assumed that the modulation method used by modulation section 103 is 16QAM.

A description will be now given in concrete terms. First, in the same way as in Embodiment 3, RV control section 102 sorts plurality of parity bits P1 through P16 of an LDPC codeword in descending order of column degree in the parity check matrix, as shown in FIG.12. Then RV control section 102 extracts parity bits four at a time in order from a parity bit of a larger column degree in the parity check matrix, and composes RV1 from P4, P6, P12, and P14, composes RV2 from P5, P6, P13, and P15, composes RV3 from P1, P3, P9, and P11, and composes RV4 from P2, P8, P10, and P16.

Also, as shown in FIG.12, RV control section 102 sorts plurality of systematic bits S1 through S8 of an LDPC codeword in ascending order of the parity check matrix, and obtains systematic bits sorted in the order S5 through S8 and S1 through S4. Also, RV control section 102 extracts systematic bits four at a time in order from a systematic bit of a smaller column degree in the parity check matrix, and composes RV5 from S5, S6, S7, and S8, and composes RV6 from S1, S2, S3, and S4. That is to say, as shown in FIG.12, RV control section 102 sorts systematic bits S1 through S8 so that the transmission order of systematic bits in the first transmission (initial transmission) and the transmission order of RV5 and RV6 composed of only systematic bits transmitted in a second and subsequent transmission (retransmission) are identical.

Thus, as shown in FIG.13, in the first transmission (initial transmission), RV control section 102 outputs sorted systematic bits S5 through S8 and S1 through S4 and RV1 to modulation section 103. Also, in the first transmission (initial transmission) shown in FIG.13, modulation section 103, for example, maps first-half four systematic bits S5 through S8 to (i₁, q₁, i₂, q₂) = (S5, S6, S7, S8), and maps second-half four systematic bits S1 through S4 to (i₁, q₁, i₂, q₂) = (S1, S2, S3, S4).

Also, in the second transmission (first retransmission), RV2 is transmitted, and all of parity bits P1 through P16 contained in an LDPC codeword are transmitted until the fourth transmission.

Here, as shown in FIG.13, when RVs are further transmitted, RV control section 102 outputs RV5 comprising systematic bits S5, S6, S7, and S8 to modulation section 103 in the fifth transmission (fourth retransmission), and outputs RV6 comprising systematic bits S1, S2, S3, and S4 to modulation section 103 in the sixth transmission (fifth retransmission). Also, in the fifth transmission (fourth retransmission) shown in FIG.13, modulation section 103 maps systematic bits S5, S6, S7, and S8 composing RV5 to (i₁, q₁, i₂, q₂) = (S7, S8, S5, S6) by switching around the mapping positions of (S5, S6) mapped to the upper two bits and (S7, S8) mapped to the lower two bits in the first transmission (initial transmission). Similarly, in the sixth transmission (fifth retransmission) shown in FIG.13, modulation section 103 maps systematic bits S1, S2, S3, and S4 composing RV6 to (i₁, q₁, i₂, q₂) = (S3, S4, S1, S2) by switching around the mapping positions of (S1, S2) mapped to the upper two bits and (S3, S4) mapped to the lower two bits in the first transmission (initial transmission).

When receiving first transmission data (initial transmission data), receiving-side radio communication apparatus 200 (FIG.6) receives systematic bits in order from a systematic bit of a smaller column degree (S5 through S8, S1 through S4). That is to say, receiving-side radio communication apparatus 200 (FIG.6) receives data symbols in the following order: a data symbol composed of S5 through S8, followed by a data symbol composed of S1 through S4. Also, when receiving fifth transmission data (fourth retransmission data), receiving-side radio communication apparatus 200 receives RV5 composed of systematic bits S5 through S8 of column degree 3, and when receiving sixth transmission data (fifth retransmission data), receiving-side radio communication apparatus 200 receives RV6 composed of systematic bits S1 through S4 of column degree 4.

That is to say, in receiving-side radio communication apparatus 200, systematic bits composing a data symbol in the first transmission (initial transmission), and systematic bits composing RV5 in the fifth transmission (fourth retransmission) and systematic bits composing RV6 in the sixth transmission (fifth retransmission), are identical. Specifically, first-half four systematic bits S5 through S8 in the first transmission (initial transmission) and S5 through S8 composing RV5 in the fifth transmission (fourth retransmission) are identical. Similarly, second-half four systematic bits S1 through S4 in the first transmission (initial transmission) and S1 through S4 composing RV6 in the sixth transmission (fifth retransmission) are identical.

Thus, RV control section 102 sorts systematic bits so as to be transmitted in order from a systematic bit of a smaller column degree in the first transmission (initial transmission), and also composes an RV by extracting systematic bits in order from a systematic bit of a smaller column degree. Consequently, RV control section 102 can control the transmission order of a plurality of systematic bits transmitted by transmitting-side radio communication apparatus 100 so as to be identical in the first transmission and in a second and subsequent transmission (the fifth transmission and sixth transmission in FIG.13). Thus, a combination of bits (here, four bits) composing one symbol can be made identical in the first transmission (initial transmission) and a second and subsequent transmission, enabling an effect of likelihood improvement due to constellation rearrangement to be obtained for all systematic bits.

That is to say, systematic bits (for example, S5, S6 or S1, S2) mapped to the upper two bits (i₁, q₁) in the first transmission (initial transmission) are mapped to the lower two bits (i₂, q₂) in the fifth transmission (fourth retransmission) and the sixth transmission (fifth retransmission). Similarly, systematic bits (for example, S7, S8 or S3, S4) mapped to the lower two bits (i₂, q₂) in the first transmission (initial transmission) are mapped to the upper two bits (i₁, q₁) in the fifth transmission (fourth retransmission) and the sixth transmission (fifth retransmission). In other words, all of systematic bits S1 through S8 are placed in the upper two bits (i₁, q₁) and lower two bits (i₂, q₂) respectively according to the first transmission (initial transmission) and the fifth transmission (fourth retransmission) and sixth transmission (fifth retransmission). By this means, the likelihoods of all systematic bits S1 through S8 can be improved evenly. By this means, error rate performance can be uniformly improved.

Thus, according to this embodiment, in the same way as in Embodiment 3, the likelihood of a systematic bit having a smaller column degree and for which the effect of likelihood improvement is small, can be supplemented by RV retransmission. Also, according to this embodiment, the likelihoods of all systematic bits can be aligned at a high level using constellation rearrangement by sorting systematic bits transmitted in the first transmission (initial transmission) into ascending column degree order -- that is, into the same transmission order as RVs transmitted in a second and subsequent transmission (retransmission). Thus, according to this embodiment, when constellation rearrangement is used together with HARQ, the error rate performance of systematic bits that are actual transmission bits can be improved to a still greater degree than in Embodiment 3, and the number of retransmissions can be minimized.

This concludes the description of embodiments of the present invention. [0105] In the above embodiments, a case in which the present invention is implemented in an FDD (Frequency Division Duplex) system has been taken as an example, but it is also possible for the present invention to be implemented in a TDD (Time Division Duplex) system. In the case of a TDD system, correlativity between uplink propagation path characteristics and downlink propagation path characteristics is extremely high, and therefore transmitting-side radio communication apparatus 100 can estimate reception quality in receiving-side radio communication apparatus 200 using a signal from receiving-side radio communication apparatus 200. Therefore, in the case of a TDD system, channel quality may be estimated by transmitting-side radio communication apparatus 100 without having receiving-side radio communication apparatus 200 issue a channel quality notification by means of a CQI.

The parity check matrix shown in FIG.2 is only an example, and a parity check matrix that can be used in implementing the present invention is not limited to that shown in FIG.2.

In the above embodiments, a case has been described in which transmitting-side radio communication apparatus 100 reports an RV index to receiving-side radio communication apparatus 200 every data transmission, but if a correspondence between the number of transmissions and RV indexes is established beforehand, and that correspondence is known by both transmitting-side radio communication apparatus 100 and receiving-side radio communication apparatus 200, receiving-side radio communication apparatus 200 can identify an RV index from the number of transmissions, and transmitting-side radio communication apparatus 100 need not report RV indexes..

In the above embodiments, RV control section 102 sorts bits of an LDPC codeword according to column degree, and composes an RV by extracting sorted bits, but RV control section 102 may omit the step of sorting bits of an LDPC codeword, and compose an RV by extracting bits directly according to column degree.

In the above embodiments, RV combining section 205 combines a padding bit and a received bit, but RV combining section 205 may combine an immediately preceding post-decoding likelihood and a received bit.

Also, error detection section 207 may perform error detection by means of a CRC (Cyclic Redundancy Check).

Furthermore, a coding rate set by control section 110 of transmitting-side radio communication apparatus 100 is not limited to one set according to channel quality, and a fixed coding rate may be used instead.

In the above embodiments, SINR is estimated as channel quality, but SNR, SIR, CINR, received power, interference power, bit error rate, throughput, an MCS (Modulation and Coding Scheme) that enables a predetermined error rate to be achieved, or the like, may be estimated as channel quality instead. Furthermore, CQI may also be expressed as CSI (Channel State Information).

In a mobile communication system, transmitting-side radio communication apparatus 100 can be provided in a radio communication base station apparatus, and receiving-side radio communication apparatus 200 can be provided in a radio communication mobile station apparatus. Also, transmitting-side radio communication apparatus 100 can be provided in a radio communication mobile station apparatus, and receiving-side radio communication apparatus 200 can be provided in a radio communication base station apparatus. By this means, a radio communication base station apparatus and radio communication mobile station apparatus can be implemented that offer the same kind of operation and effects as described above.

Also, a radio communication mobile station apparatus may be referred to as "UE," and a radio communication base station apparatus as "Node B.".

In the above embodiments, a case has been described by way of example in which the present invention is configured as hardware, but it is also possible for the present invention to be implemented by software.

The function blocks used in the descriptions of the above embodiments are typically implemented as LSIs, which are integrated circuits. These may be implemented individually as single chips, or a single chip may incorporate some or all of them. Here, the term LSI has been used, but the terms IC, system LSI, super LSI, and ultra LSI may also be used according to differences in the degree of integration.

The method of implementing integrated circuitry is not limited to LSI, and implementation by means of dedicated circuitry or a general-purpose processor may also be used. An FPGA (Field Programmable Gate Array) for which programming is possible after LSI fabrication, or a reconfigurable processor allowing reconfiguration of circuit cell connections and settings within an LSI, may also be used.

In the event of the introduction of an integrated circuit implementation technology whereby LSI is replaced by a different technology as an advance in, or derivation from, semiconductor technology, integration of the function blocks may of course be performed using that technology. The adaptation of biotechnology or the like is also a possibility.

The disclosure of Japanese Patent Application No.2008-225071, filed on September 2, 2008, including the specification, drawings and abstract, is incorporated herein by reference in its entirety.

### Industrial Applicability.

The present invention can be applied to a mobile communication system or the like.

## Claims

1. A radio communication apparatus that is a transmitting-side radio communication apparatus that extracts each bit of a codeword composed of a systematic bit and a parity bit obtained by LDPC encoding based on a parity check matrix to compose a plurality of redundancy versions, and transmits the plurality of redundancy versions sequentially, the radio communication apparatus comprising:
an encoding section that encodes a transmission bit sequence by the LDPC encoding based on the parity check matrix to generate the codeword;
a control section that controls a transmission order of the systematic bits and a transmission order of the plurality of redundancy versions according to a column degree of the parity check matrix of each bit of the codeword; and
a modulation section that generates a symbol by modulating the systematic bit or the plurality of redundancy versions,
wherein the control section controls a transmission order of the systematic bits so that all systematic bits contained in the codeword are transmitted in an initial transmission in ascending order of the column degree, controls a transmission order of the plurality of redundancy versions so that the plurality of redundancy versions composed of only parity bits are transmitted in descending order of the column degree until all parity bits contained in the codeword are transmitted, and when a redundancy version is further transmitted after all parity bits contained in the codeword have been transmitted, controls a transmission order of the plurality of redundancy versions so that the plurality of redundancy versions composed of only systematic bits are transmitted in ascending order of the column degree.

2. The radio communication apparatus according to claim 1, wherein the modulation section, when a redundancy version is further transmitted after all parity bits contained in the codeword have been transmitted, maps a symbol composed of a systematic bit belonging to each of the plurality of redundancy versions whose transmission order is controlled to a constellation point different from a constellation point to which a symbol composed of the systematic bit transmitted in an initial transmission was mapped.

3. The radio communication apparatus according to claim 1, wherein the radio communication apparatus is a radio communication base station apparatus or a radio communication mobile station apparatus.

4. A radio communication method that extracts each bit of a codeword comprising a systematic bit and a parity bit obtained by LDPC encoding based on a parity check matrix to compose a plurality of redundancy versions, and transmits the plurality of redundancy versions sequentially, the radio communication method comprising:
an encoding step of encoding a transmission bit sequence by the LDPC encoding based on the parity check matrix to generate the codeword;
a control step of controlling a transmission order of the systematic bits and a transmission order of the plurality of redundancy versions according to a column degree of the parity check matrix of each bit of the codeword; and
a modulation step of generating a symbol by modulating the systematic bit or the plurality of redundancy versions,
wherein the control step controls a transmission order of the systematic bits so that all systematic bits contained in the codeword are transmitted in an initial transmission in ascending order of the column degree, controls a transmission order of the plurality of redundancy versions so that the plurality of redundancy versions composed of only parity bits are transmitted in descending order of the column degree until all parity bits contained in the codeword are transmitted, and when a redundancy version is further transmitted after all parity bits contained in the codeword have been transmitted, controls a transmission order of the plurality of redundancy versions so that the plurality of redundancy versions composed of only systematic bits are transmitted in ascending order of the column degree.

## Amended claims

### Amended claims under Art. 19.1 PCT

**1.** Amended) A radio communication apparatus of a transmitting-side that extracts each bit of a codeword composed of systematic bits and parity bits obtained by LDPC encoding based on a parity check matrix, to compose a plurality of redundancy versions, and transmits the plurality of redundancy versions sequentially, the radio communication apparatus comprising:
an encoding section that encodes a transmission bit sequence by the LDPC encoding based on the parity check matrix to generate the codeword;
a control section that controls a transmission order of the systematic bits and a transmission order of the plurality of redundancy versions according to a column degree of the parity check matrix corresponding to each bit of the codeword; and
a modulation section that modulates the systematic bits or the plurality of redundancy versions to generate a symbol,
wherein the control section controls the transmission order of the systematic bits so that all systematic bits contained in the codeword are transmitted in an initial transmission in ascending order of the column degree, and controls the transmission order of the plurality of redundancy versions so that the plurality of redundancy versions composed of only parity bits are transmitted in descending order of the column degree until all parity bits contained in the codeword are transmitted.

**2.** Amended) The radio communication apparatus according to claim 1, wherein the control section, when a redundancy version is further transmitted after all parity bits contained in the codeword have been transmitted, controls the transmission order of the plurality of redundancy versions so that the plurality of redundancy versions composed of only systematic bits are transmitted in ascending order of the column degree.

**3.** Amended) The radio communication apparatus according to claim 1, wherein the modulation section, when a redundancy version is further transmitted after all parity bits contained in the codeword have been transmitted, maps a symbol composed of a systematic bit belonging to each of the plurality of redundancy versions whose transmission order is controlled, to a constellation point different from a constellation point to which a symbol composed of the systematic bit transmitted in the initial transmission was mapped.

**4.** Amended) The radio communication apparatus according to claim 1, wherein the radio communication apparatus is a radio communication base station apparatus or a radio communication mobile station apparatus.

**5.** Added) A radio communication method that extracts each bit of a codeword comprising systematic bits and parity bits obtained by LDPC encoding based on a parity check matrix, to compose a plurality of redundancy versions, and transmits the plurality of redundancy versions sequentially, the radio communication method comprising:
encoding a transmission bit sequence by the LDPC encoding based on the parity check matrix to generate the codeword;
controlling a transmission order of the systematic bits and a transmission order of the plurality of redundancy versions according to a column degree of the parity check matrix corresponding to each bit of the codeword; and
modulating the systematic bit or the plurality of redundancy versions to generate a symbol, wherein:
the controlling of the transmission order of the systematic bits and the transmission order of the plurality of redundancy versions comprises controlling the transmission order of the systematic bits so that all systematic bits contained in the codeword are transmitted in an initial transmission in ascending order of the column degree, and controlling the transmission order of the plurality of redundancy versions so that the plurality of redundancy versions composed of only parity bits are transmitted in descending order of the column degree until all parity bits contained in the codeword are transmitted.
